# EUROPEAN PATENT APPLICATION

(11) **EP 1 577 949 A1**
(43) Date of publication of application: **21.09.2005**
(21) Application number: 04075849.2
(22) Date of filing: 16.03.2004
(51) Int. Cl.: H01L 27/00, H01L 51/20

(54) **Flexible organic electronic device and methods for preparing the same**

(71) Applicant: Nederlandse Organisatie voor Toegepast-Natuurwetenschappelijk Onderzoek TNO, 2628 VK Delft (NL)
(72) Inventor: van Mol, Antonius Maria Bernardus, 5658 HC Eindhoven (NL); Grob, Frank Theodorus Johannes, 5651 AS Eindhoven (NL); Linden, Joannes Leonard, 5614 AC Eindhoven (NL)
(74) Representative: Winckels, Johannes Hubertus F.

(57) **Abstract**

The invention provides a method for preparing a flexible organic electronic device comprising at least a first electrode comprising a transparent conductive oxide layer, an organic active layer, a second electrode and a polymeric substrate layer, whereby the transparent conductive layer is applied on a removable substrate layer or one or more transparent layers previously applied onto the removable substrate layer at a temperature of at least 250°C, and the removal carrier is removed when the polymeric substrate layer has been applied.

The invention further provides a flexible organic electronic device obtainable by said method.

## Description

The present invention relates to a flexible organic electronic device such as a display or a thin film transistor (TFT), and methods for preparing said device.

Displays are very thin screens that are widely used in machine vision systems such as portable computers and television sets. Such displays include light-emitting diodes (LEDs), organic light-emitting diodes (OLEDs), liquid crystal displays (LCDs) and field emission displays (FEDs). Displays are semiconductor devices that emit light under influence of an applied voltage. They generally comprise a substrate and an active layer, which is situated between a front electrode in the form of a transparent conductive layer and a back electrode layer. When an appropriate voltage is applied between the transparent conductive layer and the back electrode, light will be produced in the active layer, which light emits through the transparent conductive layer.

Thin film transistors (TFTs) are semiconductor devices which are used in electronic applications such as displays and electronic bar codes. They comprise a transparent conductive oxide layer that acts as gate electrode, a dielectric layer, a semiconductor layer, and a source and drain electrode. When an appropriate voltage is applied to the gate electrode, a conductive path is created between the source and the drain electrode which makes electronic switching possible.

Conventional electronic devices as described above comprise inflexible substrates that are made of glass. Such substrates have the drawbacks that they are breakable and relatively heavy. In order to deal with these drawbacks flexible substrates have been developed that are cheaper, lighter and have increased ruggedness when compared to substrates that are made of glass.

In addition, it is observed that there exists the increasing desire to use organic active layers in electronic devices because such devices display improved properties in terms of processing, brightness, energy demand, and compatibility with flexible applications when compared with conventional electronic devices.

Flexible electronic devices that comprise a polymeric substrate and an organic active layer have, however, the drawback that they can only be prepared at relatively low temperatures because the relative poor temperature stability of the polymeric materials of which the substrates are made to provide flexibility. Hence, high temperature deposition processes such as, for instance, Atmospheric Pressure Chemical Vapour Deposition (APCVD) cannot be applied to deposit a transparent conductive oxide layer onto the substrate. Consequently, in most, if not all, flexible displays indium tin oxide is used as the transparent conductive oxide because this material can suitably be deposited at a low temperature using Physical Vapour Deposition (PVD) processes.

An additional problem with flexible organic electronic devices is that the device comprising an organic active layer needs to be protected against possible contact with water and oxygen, because these materials have a detrimental impact on the performance of the organic device. To provide such a protection presently a stack of several layers has to be provided additionally.

As regards the use of indium tin oxide it should be noted that it is a relatively expensive transparent conductive oxide and that the PVD processes used in connection with it are relatively slow and are operated at low pressure necessitating the need for expensive vacuum equipment. In addition, the performance of indium tin oxide, as far as the protection of the organic active layer is concerned, leaves considerable room for improvement.

Object of the present invention is to provide a flexible organic electronic device that has an improved long-term performance and is cheaper to make.

Surprisingly, it has now been found that flexible organic electronic devices with excellent long-term performance properties can be prepared when use is made of a removable substrate layer onto which a transparent conductive oxide layer can be applied at a high temperature, after which the removable substrate layer is removed at a later stage of the preparation process.

Accordingly, the present invention relates to a method for preparing a flexible organic electronic device comprising at least a first electrode comprising a transparent conductive oxide layer, an organic active layer, a second electrode and a polymeric substrate layer, whereby the transparent conductive layer is applied on a removable substrate layer or one or more transparent layers previously applied onto the removable substrate layer at a temperature of at least 250°C, and the removal carrier is removed when the polymeric substrate layer has been applied.

The use of such a removable substrate allows the use of high temperature deposition processes, which makes it possible that cheaper transparent conductive oxides can be used and that the deposition processes can be carried out much faster. Additionally, it allows the formation of a transparent conductive oxide layer having improved properties to protect the polymeric substrate against water and oxygen, because it displays very low water and oxygen permeabilities.

Suitably, the method according to the present invention comprises the steps of:
a) applying the first electrode which comprises a transparent conductive oxide layer onto the removable substrate layer or on one or more transparent layers previously applied onto the removable substrate layer;
b) applying the organic active layer onto the transparent conductive layer;
c) applying the second electrode onto the organic active layer;
d) applying the polymeric substrate layer onto the second electrode ; and
e) removing the removable substrate layer.

In another, and preferred, embodiment of the present invention the method comprises the steps of:
a) applying the first electrode which comprises a transparent conductive oxide layer onto the removable substrate layer or one or more transparent layers previously applied onto the removable substrate layer;
b) applying the polymeric substrate layer onto the transparent conductive layer;
c) removing the removable substrate layer;
d) applying the organic active layer onto the transparent conductive layer;
e) applying the second electrode onto the organic active layer; and
f) applying a further polymeric substrate layer onto the second electrode.

The transparent conductive oxide layer can suitably be applied onto the removable substrate layer by means of a deposition process such as Hot spraying, Atomic Layer Deposition (ALD), sol/gel deposition, Atmospheric Pressure Chemical Vapour Deposition (APCVD), Low Pressure Chemical Vapour Deposition (LPCVD) or a Plasma Enhanced Chemical Vapour Deposition (PECVD) process. The transparent conductive oxide layer is preferably applied onto the removable substrate by means of a APCVD process. The transparent conductive oxide layer is suitably applied onto the removable substrate layer or one or more transparent layers previously applied onto the removable substrate layer at a temperature of at least 250°C, preferably at least 400°C, more preferably at a temperature in the range of from 450 to 550°C, and most preferably in the range of from 490 to 530°C. The application of such high temperatures allows the transparent conductive layer to obtain the desired properties.

The transparent conductive oxide layer may comprise one or more transparent conductive oxides selected from the group consisting of zinc oxide, tin oxide, zinc stannate, and/or indium tin oxide. Preferably, the transparent conductive oxide layer comprises zinc oxide and/or tin oxide. More preferably, the transparent conductive oxide layer comprises tin oxide. The transparent conductive oxide can be doped with a material such as aluminium, fluorine, gallium or boron. Most preferably, the transparent conductive oxide layer comprises tin oxide which has been doped with fluorine. The thickness of the transparent conductive oxide layer can suitably be in the range of from 10 nm to 2000 nm, preferably in the range of from 450 nm to 850 nm.

The removable substrate layer can suitably be a foil of a metal or a metal alloy. Suitable metals include aluminium, titanium, copper, steel, iron, nickel, silver, zinc, molybdenum, chromium and alloys thereof. Preferably aluminium, copper or iron is used or an alloy thereof. Most preferably, use is made of aluminium or an alloy thereof. The removable substrate layer can suitably have a thickness in the range of from 5 micron to 1 mm, preferably in the range of from 50 micrometer to 200 micrometer.

The removable substrate layer can suitably be removed by means of an etching process. Suitably, in such etching process use is made of an acid or a base such as nitric acid, sulphuric acid, sodium hydroxide (NaOH) or potasium hydroxide (KOH). When the removable substrate layer comprises a foil of aluminium preferably use is made of sodium hydroxide (NaOH) or potassium hydroxide (KOH).

On the removable substrate layer one or more transparent layers may already have been applied, before the transparent conductive oxide layer is applied. Such transparent layers include layers comprising SiO₂, SiO₂₋ₓ, Al₂O₃, ZnO, ZrO₂, TiO₂, TiN, ZnS, SiOₓC_{y}, Si₃N₄ and/or SiOₓN_{y}. The polymeric substrate layer may contain several layers that can suitably comprise one or more polymeric materials selected from the group consisting of polyimids, polyamids, polyaramids, polyesters, polyolefins, liquid crystalline polymers (LCP), polycarbonates, polyacrylates, polymethacrylates, copolymers, blends of polymers and/or composites. The polymeric substrate layer may contain one or more types of polymers, but in practice it will be preferred to use one particular type of polymer. Preferably, the polymeric substrate layer comprises polyesters and/or polyolefins. More preferably, the polymeric substrate layer comprises polyethyleneterephthalate (PET) or polyethylenenaphthalate (PEN). The polymeric substrate layer can suitably have a thickness in the range of from 50 micrometers to 10 centimeters, preferably in the range of from 100 to 500 micrometer. The polymeric substrate layer can suitably applied to the second electrode layer and the transparent conductive layer by means of lamination.

The organic active layer can suitably comprise light emitting organic molecules, one or more semiconducting polymers such as light emitting polymers, one or more conducting polymers and/or one or more semiconducting polymers selected from the group consisting of polyanilines, polythiophenes, polypyroles, polyfluorenes, polyarylenes, polycabazoles, polyvinylcarbazoles, and derivatives, copolymers, and/or mixtures of these. The organic active layer may contain one or more layers of the above named compounds, but in practice it will be preferred to use polyaniline or polyethylenedioxythiophene in one layer and the second organic active layer comprises the light emitting polymer. The organic active layer can suitably have a thickness in the range of from 20 to 500 nm, preferably in the range of from 50 to 150nm. The organic active layer can suitably be applied onto the transparent conductive oxide layer by means of spin coating or printing processes such as doctor blading, screenprinting or inkjet printing. The organic active layer is preferably applied onto the back electrode layer at a temperature below 100°C.

The second electrode may comprise a low work function material such as calcium, barium, lithium fluoride, magnesium covered with a layer of aluminium, silver or gold.

The second electrode can suitably have a thickness in the range of from 1 nm to 1 micrometer, preferably in the range from 1nm to 200nm. The second electrode can suitably be applied onto the organic active layer by means of sputtering or low pressure vapour deposition or a printing process. The second electrode is preferably applied onto the organic active layer by means of a low pressure vapour deposition process. The second electrode layer is preferably applied onto the polymeric substrate layer at a temperature below 100 °C.

It will be appreciated by the skilled person that in displays the second electrode will comprise a back electrode, whereas in TFTs the second electrode will comprise both a source and drain electrode.

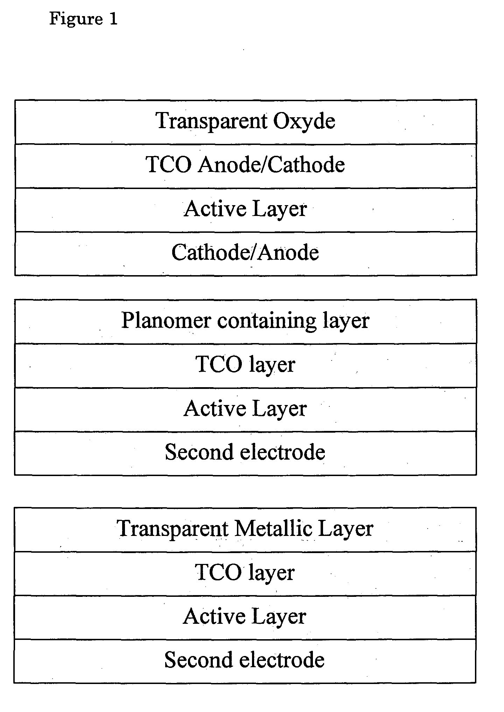

The transparent conductive oxide layer obtained in accordance with the present invention constitutes a very effective carrier layer which protects the active layer against water and oxygen. Depending on the particular use of the electronic device a further barrier layer may be applied on the transparent conductive oxide layer, before or after the removable substrate layer is removed in step e). Such further barrier layer may for instance comprise a transparent oxide layer, a planomer containing layer or a transparent metallic layer. Various of these embodiments have been depicted in Figure 1. The transparent oxide layer may for instance comprise SiO₂, SiO_{2-x,} Al₂O₃, ZnO, ZrO₂, TiO₂, TiN, ZnS, SiOₓC_{y}, Si₃N₄ and/or SiOₓN_{y}. The planomer is a nanocomposite consisting of a plate-like, non-permeable mineral and a polymer matrix, whereby the plates are very thin, preferably between 1 and 10 nm and have an aspect ratio of at least 100. Preferably, such a mineral is formed from the mineral class of montmorrilonites, hectorites, and saponites. The minerals exist preferentially in an exfoliated state within the polymer matrix material, i.e. the plates are separately dispersed. The matrix polymer can be chosen out of known transparent barrier materials. The transparent metallic layer may comprise Al, Ti, Cr, Ni, Ag or Mg. Such further barrier layer can suitably have a thickness in the range from 1nm to 1 □m, preferably in the range of from 5 to 100 nm Alternatively, polymeric substrate layer is applied directly on the transparent conductive oxide layer before or after the removable substrate layer has been removed in step e).

A polymeric substrate layer can be applied onto the further barrier layer to provide strength and flexibility. Such further polymeric substrate layer can suitably have a thickness in the range of from 1 □m to 10 mm, preferably in the range of from 50 □m to 1 mm.

As mentioned earlier, the flexible organic electronic devices according to the present invention can for instance be used in LCD-displays, thin film transistor technology, and organic light-emitting diodes (OLEDs). In a particular embodiment of the present invention the device comprises an organic light-emitting diode.

The flexible organic electronic devices obtained in accordance with the methods of the present invention display unique properties in terms of water and oxygen permeabilities.

Hence, the present invention also relates to a flexible organic electronic device obtainable by a method according to the present invention.

The present invention also relates to a flexible organic electronic device comprising at least a first electrode which comprises transparent conductive oxide layer, an organic active layer, a second electrode , and a polymeric substrate layer, wherein the transparent conductive oxide layer has very low water and oxygen permeabilities. Suitably, the transparent conductive oxide layer displays a water permeability of less than 0.01g/m²/day, preferably less than 10⁻⁵ g/m²/day, whereas it displays an oxygen permeability of less than 10⁻¹ cc/m²/day, preferably less than 10⁻² cc/m²/day.

Another advantage of the flexible organic electronic device in accordance with the present invention is that by adjustment of the preparation conditions the transparent conductive oxide layer can obtain a surface structure that allows emission of diffused light. This is attractive for applications in the field of displays.

## Claims

1. A method for preparing a flexible organic electronic device comprising at least a first electrode comprising a transparent conductive oxide layer, an organic active layer, a second electrode and a polymeric substrate layer, whereby the transparent conductive layer is applied on a removable substrate layer or one or more transparent layers previously applied onto the removable substrate layer at a temperature of at least 250°C, and the removable carrier is removed when the polymeric substrate layer has been applied.

2. A method according to claim 1 comprising the steps of:
a) applying the first electrode which comprises a transparent conductive oxide layer onto the removable substrate layer or on one or more transparent layers previously applied onto the removable substrate layer;
b) applying the organic active layer onto the transparent conductive layer;
c) applying the second electrode onto the organic active layer;
d) applying the polymeric substrate layer onto the second electrode ; and
e) removing the removable substrate layer.

3. A method according to claim 1 comprising the steps of:
a) applying the first electrode which comprises a transparent conductive oxide layer onto the removable substrate layer or one or more transparent layers previously applied onto the removable substrate layer;
b) applying the polymeric substrate layer onto the transparent conductive layer;
c) removing the removable substrate layer;
d) applying the organic active layer onto the transparent conductive layer;
e) applying the second electrode onto the organic active layer; and
f) applying a further polymeric substrate layer onto the second electrode.

4. A method according to one of claims 1-3, wherein the one or more transparent layers previously applied onto the removable substrate layer comprise one or more transparent oxides selected from the group consisting of SiO₂, SiO₂₋ₓ, Al₂O₃, ZnO, ZrO₂, TiO₂, TiN, ZnS, SiOₓC_{y}, Si₃N₄ and/or SiOₓN_{y}.

5. A method according to any one of claims 1-4, wherein the transparent conductive oxide layer is applied onto the removable substrate layer or one or more transparent layers previously applied onto the removable substrate layer by means of deposition process such as Atomic Layer Deposition (ALD), sol/gel deposition, hot spraying, Atmospheric Pressure Chemical Vapour Deposition (APCVD), Low Pressure Chemical Vapour Deposition (LPCVD) or a Plasma Enhanced Chemical Vapour Deposition (PECVD) process.

6. A method according to claim 5, wherein the transparent conductive oxide layer is applied onto the removable substrate layer or one or more transparent layers previously applied onto the removable substrate layer by means of a APCVD process.

7. A method according to any one of claims 1-6, wherein the organic active layer is applied onto the transparent conductive oxide layer by means of a spin coating or a printing process.

8. A method according to any one of claims 1-7, wherein the second electrode is applied onto the organic active layer by means of a sputtering, plasma enhanced chemical vapour deposition (PECVD), or a low pressure vapour deposition process.

9. A method according to any one of claims 1-8, wherein the removable substrate layer is removed by means of an etching process.

10. A method according to any of claims 1-9, wherein a planomer layer is applied onto the transparent conductive oxide layer.

11. A method according to any of claims 1-10, wherein a transparent metal layer is applied onto the transparent conductive oxide layer.

12. A method according to any one of claims 1-11 wherein a polymeric substrate layer is applied onto the second electrode and the transparent conductive oxide layer by means of a lamination process.

13. A method according to any one of claims 1-12, wherein the transparent conductive oxide layer comprises flourine doped tin oxide.

14. A method according to any one of claims 1-13, wherein the polymeric substrate layer comprises polyesters, polyimids and/or polyolefins.

15. A method according to any one of claims 1-14, wherein the second electrode comprises calcium, barium, lithium fluoride, and/or magnesium covered with a layer of aluminium, silver or gold.

16. A method according to any one of claims 1-15, wherein the removable substrate layer comprises a foil of aluminium.

17. A flexible organic electronic device obtainable by a process according to any one of claims 1-16.

18. A device according to claim 17, wherein the transparent layers above the organic active layer display a water permeability of less than 0.01g/m²/day, and an oxygen permeability of less than 10⁻² cc/m²/d.

19. A device according to claim 17 or 18, wherein the device is a light emitting diode (LED).
